Europäisches Patentamt

European Patent Office

Office européen des brevets

(11) Veröffentlichungsnummer: **0 517 201 A1**

# EUROPÄISCHE PATENTANMELDUNG

(21) Anmeldenummer: **92109419.9**

(22) Anmeldetag: **04.06.92**

(51) Int. Cl.5: **G03F 7/26, A62D 3/00**

(30) Priorität: **07.06.91 DE 4118830**

(43) Veröffentlichungstag der Anmeldung:
**09.12.92 Patentblatt 92/50**

(84) Benannte Vertragsstaaten:
**AT CH DE ES FR GB IT LI**

(71) Anmelder: **HOECHST AKTIENGESELLSCHAFT**
**Postfach 80 03 20**
**W-6230 Frankfurt am Main 80(DE)**

(72) Erfinder: **Fey, Andreas**
**Parkstrasse 25a**
**W-6750 Kaiserslautern(DE)**

(54) **Vorrichtung zur Entsorgung von fotopolymeren Materialien.**

(57) Eine Vorrichtung zur Entsorgung von fotopolymeren Materialien besteht aus einem mit einer Klappe (2) verschließbaren Gehäuse (1), in welchem ein oder mehrere UV-Strahler (3) angebracht sind, welche über ein durch die Klappe (2) betätigbares Schaltmittel im verschlossenen Zustand des Gehäuses (1) einschaltbar sind. Das Gehäuse weist einen Einsatz (4) aus durchsichtigem Material auf, welcher zur Aufnahme der fotopolymeren Abfälle dient. Durch die Strahlung der UV-Strahler (3) werden die Fotoresistschichten der Abfälle polymerisiert und können in diesem Zustand über den Hausmüll entsorgt werden, während sie im unpolmyerisierten Zustand Sondermüll bilden, der entsprechend aufwendig entsorgt werden muß.

Die Vorrichtung zur Entsorgung ist für beim Laminieren entstehende fotopolymerisierbare Abfälle und auch für Freidruckfolien, bedruckt mit fotopolymerem Lötstoplack, geeignet.

Fig. 2

EP 0 517 201 A1

Die Erfindung betrifft eine Vorrichtung zur Entsorgung von fotopolymeren Materialien.

Bei der Herstellung von Leiterplatten fallen Fotoresiste an, die in unpolymerisiertem Zustand als Sondermüll entsorgt werden müssen.

Die Aufgabe der Erfindung besteht nun darin, eine Vorrichtung zur Entsorgung von fotopolymeren Materialien anzugeben.

Diese Aufgabe wird durch eine Vorrichtung, bestehend aus einem mit einem Deckel oder einer Klappe verschließbaren Gehäuse, in welchem ein oder mehrere UV-Strahler angebracht sind, welche über ein durch den Deckel bzw. die Klappe betätigbares Schaltmittel im verschlossenen Zustand des Gehäuses einschaltbar sind, gelöst.

Durch die Einwirkung der UV-Strahlung auf die fotopolymeren Abfälle werden diese in den polymerisierten Zustand überführt, in welchem diese als Hausmüll entsorgt werden können. Die erfindungsgemäße Vorrichtung ist nicht nur für die Entsorgung von Fotoresisten, die beim Laminieren von Leiterplatten entstehen, geeignet, ebenso können auch Freidruckfolien entsorgt werden, welche mit fotopolymerem Lötstoplack behandelt sind. Da die Vorrichtung in dem Arbeitsraum aufstellbar ist, in welchem die Abfälle anfallen, ist durch ein durch den Deckel oder die Klappe betätigbares Schaltmittel sichergestellt, daß die UV-Strahlung beim Öffnen des Deckels oder der Klappe nicht aus dem Gehäuse der Vorrichtung dringt.

Vorteilhafte Weiterbildungen ergeben sich aus den Unteransprüchen.

Die Erfindung wird anhand eines Ausführungsbeispiels naher erläutert, welches in der Zeichnung dargestellt ist. Es zeigt:

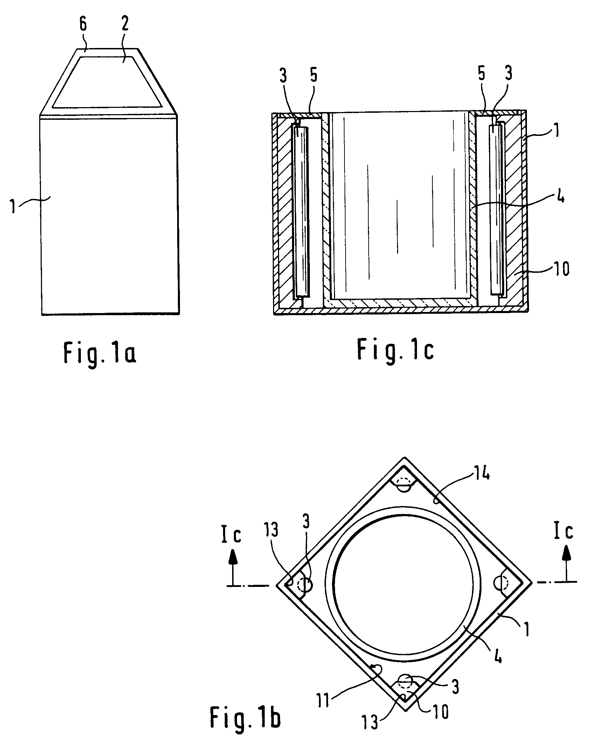

Figur 1a: Die Seitenansicht der Vorrichtung.

Figur 1b: Die Draufsicht auf die Vorrichtung mit abgenommenem Aufsatz.

Figur 1c: Einen senkrechten Diagonalschnitt durch das Gehäuse der Vorrichtung und

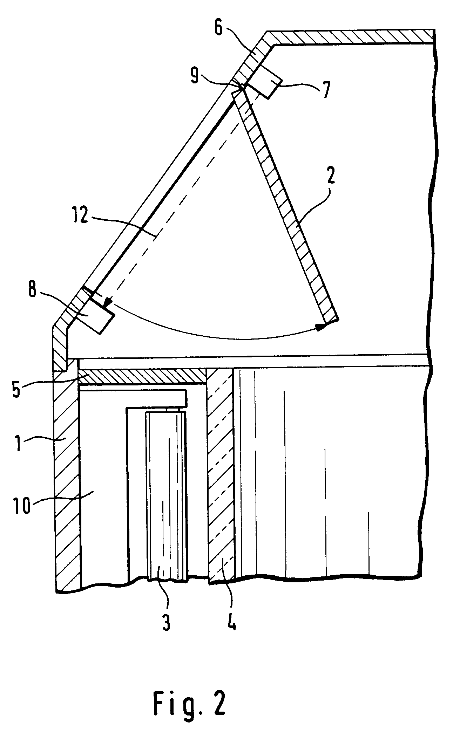

Figur 2: Einen Teil des Gehäuses und des Aufsatzes mit der Klappe im Schnitt.

Das Gehäuse 1 hat vorzugsweise einen quadratischen Grundriß, in mindestens zwei gegenüberliegenden Ecken 13 ist jeweils ein UV-Strahler an einer am Gehäuse 1 befestigten Halterung 10 angebracht, wobei die Länge des UV-Strahlers 3 ungefähr der Höhe des Gehäuses 1 entspricht. Im Gehäuse 1 befindet sich ein zylinderförmiger Einsatz 4, welcher nach oben hin geöffnet ist und aus einem durchsichtigen oder durchscheinenden Material besteht. Der Einsatz 4 dient zur Aufnahme eines aus durchsichtiger bzw. durchscheinender Folie bestehenden Entsorgungsbehälters, zur Aufnahme der die Fotoresiste tragenden Abfälle.

Das Gehäuse 1 ist durch eine Abdeckung 5 abgedeckt, welche eine entsprechende Öffnung für den Einsatz 4 aufweist.

Auf das Gehäuse 1 ist ein Aufsatz 6 aufgesetzt, welcher eine durch ein Scharnier 9 bewegbare Klappe 2 aufweist. Die Klappe 2 liegt in der Ruhelage parallel oder fluchtend an der Schrägfläche des Aufsatzes 6 an und wird durch eine nicht gezeigte Feder in dieser Lage gehalten. Sobald die Klappe 2 geöffnet wird, wird durch ein nicht gezeigtes Schaltmittel der elektrische Stromkreis der UV-Strahler 3 unterbrochen, so daß diese abgeschaltet werden. Die Bewegung der Klappe 2 kann beispielsweise durch eine Lichtschranke überwacht werden, welche aus einem Sender 7 und einem Empfänger 8 gebildet wird, welche an der Innenseite des Aufsatzes 6 angebracht sind. Sobald der Empfang des vom Sender 7 ausgesendeten Lichtstrahles 12 durch die Bewegung der Klappe 2 unterbrochen wird, erfolgt die Abschaltung der Stromversorgung der UV-Strahler. Damit ist sichergestellt, daß beim Öffnen der Klappe keine Strahlung der UV-Strahler 3 aus dem Aufsatz 6 nach außen dringt. Da der Aufsatz 6 auf das Gehäuse 1 aufgesetzt ist, kann beim Abhehmen desselben Strahlung der UV-Strahler nach außen dringen. Um dies zu verhindern, ist ein weiteres nicht gezeigtes Schaltmittel vorgesehen, welches die Lage des Aufsatzes 6 auf dem Gehäuse 1 überwacht. Sobald der Aufsatz 6 von dem Gehäuse 1 abgehoben wird, spricht das Schaltmittel an und unterbricht ebenfalls die Stromversorgung der UV-Strahler. Beide Schaltmittel sind zweckmäßigerweise hintereinander geschaltet, so daß sowohl durch Ansprechen des einen als auch des anderen Schaltmittels die Stromversorgung der UV-Strahler unterbrochen wird.

Die Schaltmittel können derart ausgebildet sein, daß bereits vor Öffnen der Klappe 2 der Stromkreis geöffnet und nach Schließen der Klappe der Stromkreis verzögert geschlossen wird.

Durch die Einwirkung der Strahlung der UV-Strahler auf die fotopolymeren Abfälle im Einsatz 4 werden diese polymerisiert, so daß sie dann als Hausmüll und nicht mehr als Sondermüll entsorgt werden können. Zur Steigerung der Intensität der Strahlung ist es denkbar, die Innenseiten 11 des Gehäuses 1 mit einer strahlungsreflektierenden Schicht 14 auszustatten.

**Patentansprüche**

1. Vorrichtung zur Entsorgung von fotopolymeren Materialien, bestehend aus einem mit einem Deckel oder einer Klappe (2) verschließbaren Gehäuse (1), in welchem ein oder mehrere UV-Strahler (3) angebracht sind, welche über ein durch den Deckel bzw. die Klappe (2) betätigbares Schaltmittel im verschlossenen Zustand des Gehäuses einschaltbar sind.

2. Vorrichtung zur Entsorgung nach Anspruch 1, dadurch gekennzeichnet, daß das Gehäuse (1) eine quadratische Grundfläche aufweist, daß in mindestens zwei gegenüberliegenden Ecken (13) des Gehäuses (1) jeweils ein stabförmiger UV-Strahler (3) angebracht ist, dessen Länge annähernd der Höhe des Gehäuses (1) entspricht, daß im Gehäuse (1) ein zylinderförmiger Einsatz (4) aus durchsichtigem oder durchscheinendem Material angeordnet ist, dessen Höhe gleich der Höhe des Gehäuses (1) ist und daß auf dem Gehäuse ein abnehmbarer Aufsatz (6) mit einer Klappe (2) aufsitzt.

3. Vorrichtung zur Entsorgung nach Anspruch 2, dadurch gekennzeichnet, daß das Gehäuse (1) eine das Gehäuse abschließende Abdeckung (5) aufweist, welche den Einsatz (4) umschließt.

4. Vorrichtung zur Entsorgung nach Anspruch 1, dadurch gekennzeichnet, daß ein Schaltmittel vor Öffnen des Deckels oder der Klappe (2) den Stromkreis für die UV-Strahler (3) unterbricht.

5. Vorrichtung zur Entsorgung nach Anspruch 1 oder 2, dadurch gekennzeichnet, daß das Schaltmittel nach Schließen des Deckels oder der Klappe (2) den Stromkreis für die UV-Strahler (3) verzögert schließt.

6. Vorrichtung zur Entsorgung nach einem der Ansprüche 1 bis 5, dadurch gekennzeichnet, daß die Seitenflächen (14) des Gehäuses (1) auf der Innenseite mit einer Reflexionsschicht (11) ausgestattet sind.

7. Vorrichtung zur Entsorgung nach Anspruch 1 oder 2, dadurch gekennzeichnet, daß durch den auf dem Gehäuse (1) aufliegenden Aufsatz (6) ein weiteres Schaltmittel betätigt wird.

8. Vorrichtung zur Entsorgung nach Anspruch 7, dadurch gekennzeichnet, daß beide Schaltmittel in Reihe geschaltet sind.

Fig.1a

Fig.1c

Fig.1b

Fig. 2

## EUROPÄISCHER RECHERCHENBERICHT

Europäisches
Patentamt

**EUROPÄISCHER RECHERCHENBERICHT**

Nummer der Anmeldung

EP 92 10 9419

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| P,X<br>Y | US-A-5 059 635 (MON ET AL.)<br>* Zusammenfassung *<br>* Spalte 2, Zeile 31 - Spalte 2, Zeile 51;<br>Ansprüche; Abbildung 1 *<br>& CA-A-2 018 526 (AMERICAN TEL & TELEG CO) 15.<br>Dezember 1990<br>--- | 1-8<br>1-8 | G03F7/26<br>A62D3/00 |
| Y | DE-A-3 044 181 (HAAG)<br>* Ansprüche *<br>--- | 1-8 | |
| A | WORLD PATENTS INDEX LATEST<br>Week 3689,<br>Derwent Publications Ltd., London, GB;<br>AN 89-261635<br>& SU-A-1 440 890 (ROAD RES INST) 30. November<br>1988<br>* Zusammenfassung *<br>----- | 1-8 | |
| | | | **RECHERCHIERTE SACHGEBIETE (Int. Cl.5 )**<br><br>G03F<br>A62D |

Der vorliegende Recherchenbericht wurde für alle Patentansprüche erstellt

| Recherchenort | Abschlußdatum der Recherche | Prüfer |
|---|---|---|
| DEN HAAG | 20 AUGUST 1992 | D. Hillebrecht |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes
    Dokument

EPO FORM 1503 03.82 (P0403)